# DEMANDE DE BREVET EUROPEEN

(11) **EP 0 778 670 A1**
(43) Date de publication de la demande: **11.06.1997**
(21) Numéro de dépôt: 96203344.5
(22) Date de dépôt: 27.11.1996
(51) Int. Cl.: H03K 17/66

(54) **Circuit de commutation de courant dans une charge principalement inductive**

(30) Priorité: 06.12.1995 FR 9514421
(71) Demandeur: PHILIPS COMPOSANTS ET SEMICONDUCTEURS, 92150 Suresnes (FR); PHILIPS ELECTRONICS N.V., 5621 BA Eindhoven (NL)
(72) Inventeur: Leclerc, Patrick, 75008 Paris (FR)
(74) Mandataire: Caron, Jean

(57) **Abrégé**

Circuit de type amplificateur en "H" dans lequel au moins deux miroirs de courant (M1, M2) sont utilisés pour alimenter la charge (L) en courant, alternativement dans un sens et dans l'autre.

Pour accélérer la mise en conduction des miroirs de courant, une capacité (20, 21) est associée à chacun d'eux, laquelle est alternativement, couplée en parallèle sur l'entrée du miroir de courant auquel elle est associée lorsque ce miroir débite, et couplée aux bornes de la tension d'alimentation (V2 - V1) lorsque ce miroir ne débite pas, opération qui est réalisée au moyen d'un jeu d'interrupteurs (S3, S4, S5, S6).

Application au pilotage d'une tête d'écriture sur disque magnétique.

## Description

La présente invention concerne un circuit de commutation de courant d'une charge, comportant au moins deux miroirs de courant présentant chacun une entrée et une sortie, disposés de manière à alimenter la charge entre deux bornes d'une alimentation, alternativement dans un sens ou dans l'autre, via la sortie de l'un ou de l'autre des miroirs de courant, chacun étant alternativement actionné au moyen d'un courant de commande injecté dans son entrée.

Un circuit de ce type, destiné à l'alimentation d'une tête d'écriture de disque dur, est décrit dans un article intitulé : "150 Mb/s Write Amplifier for Hard Disk Drives with Near Rail-to Rail Voltage Swing" de H. Veenstra et al, publié dans les "Proceedings ESSCIRC'95", Lille (FR) 19-21 september 1995, pp. 434-437.

Dans le circuit connu, quatre miroirs de courant sont disposés en une configuration en "H", pour l'alimentation de la charge représentée par la tête d'écriture, et deux miroirs de courant, alternativement selon une diagonale de la configuration puis selon l'autre, sont alimentés par des sources de courant commutées pour débiter soit une valeur de courant nominale soit une valeur nulle.

Le circuit connu est réalisé avec des transistors bipolaires et pour obtenir une vitesse de commutation satisfaisante il est nécessaire que les transistors PNP des deux miroirs de courant qui sont couplés à la tension d'alimentation positive, soient des transistors de structure verticale. Or le processus technologique pour obtenir de tels transistors est complexe et onéreux surtout lorsqu'il est conçu pour pouvoir réaliser simultanément des transistors à effet de champ MOS, qui eux, sont utilisés avantageusement pour la réalisation de la logique de contrôle.

Par ailleurs, le circuit de commutation connu du document cité met en oeuvre une technique de neutrodynage pour atteindre les performances de rapidité recherchées. Or cette technique est délicate et peut donner lieu à une instabilité du circuit.

Aussi, l'un des buts de l'invention est-il de proposer un circuit de commutation présentant des performances comparables à celles du circuit connu mais susceptible d'être obtenu par un procédé plus classique et peu onéreux.

Un autre but de l'invention est encore de fournir un circuit qui évite un recours à la technique de neutrodynage et procure un résultat comparable par d'autres moyens ne risquant pas de perturber la stabilité de fonctionnement.

En effet, selon la présente invention, un circuit de commutation de courant du type mentionné dans le paragraphe introductif est caractérisé en ce qu'à chacun des miroirs de courant est associée une capacité et un jeu de dispositifs interrupteurs, connectés et actionnés de manière à coupler la capacité, soit en parallèle sur l'entrée du miroir de courant auquel elle est associée lorsque ce miroir, recevant le courant de commande, débite, soit aux bornes de l'alimentation lorsque ce miroir de courant ne débite pas.

En l'absence des capacités associées aux miroirs de courant, les capacités parasites d'entrée de miroirs de courant se chargent par le courant de commande ce qui provoque un délai de réponse des miroirs. Conformément à l'invention, la charge des capacités parasites d'entrée des miroirs de courant peut être obtenue très rapidement par l'apport des charges électriques stockées dans les capacités. Comme ces charges électriques peuvent être stockées sous une tension nettement plus élevée que la tension d'entrée des miroirs de courant, et par exemple une tension égale à la tension d'alimentation, les capacités en question peuvent être de valeur réduite et donc facilement intégrées au sein du circuit lui-même.

L'invention présente un avantage d'autant plus important que le courant de commande des miroirs est plus faible. Ainsi, sans perte de rapidité de commutation, des transistors de taille réduite peuvent être utilisés pour réaliser la source de courant de commande dans un mode préféré de mise en oeuvre de l'invention selon lequel les miroirs de courant présentent un rapport courant de sortie sur courant d'entrée qui est supérieur à l'unité.

Une économie de surface de semiconducteur peut également être obtenue dans un circuit de commutation caractérisé en outre en ce que le courant de commande injecté alternativement dans l'un ou l'autre des miroirs de courant provient d'une même source de courant dont le courant est commuté vers l'une ou l'autre des entrées des miroirs de courant par des dispositifs interrupteurs.

En plus d'une accélération des miroirs de courant dans la phase transitoire où ils passent d'un débit nul à un débit nominal, ces miroirs peuvent également être accélérés dans la phase transitoire inverse, selon une disposition caractérisée en ce que, en parallèle sur l'entrée de chacun des miroirs de courant, est connecté un dispositif interrupteur additionnel, actionné de manière à shunter cette entrée lorsque le miroir de courant ne débite pas.

L'invention telle que définie jusqu'ici peut être appliquée indifféremment à un circuit à transistors bipolaires ou à transistors à effet de champ, et indépendamment du fait que les miroirs de courant soient au nombre de quatre ou au nombre de deux seulement, deux dispositifs interrupteurs effectuant alors la commutation nécessaire, d'un même côté de la tension d'alimentation, par exemple du côté de la borne positive.

Le circuit de commutation selon l'invention présente toutefois des avantages particuliers en ce qui concerne son prix de revient lorsque le circuit est formé de transistors à effet de champ MOS aussi bien pour constituer les dispositifs interrupteurs mentionnés précédemment, que pour former les miroirs de courant.

Enfin, l'invention concerne également un appareil de stockage d'informations numériques utilisant une tête d'écriture de type inductif, tel qu'un "disque dur" utilisé dans le domaine de l'informatique caractérisé en ce que pour actionner la tête d'écriture, il comporte un circuit de commutation de courant tel que défini précédemment.

La description qui va suivre en regard des dessins annexés, donnés à titre d'exemples non limitatifs, fera bien comprendre en quoi consiste l'invention et comment elle peut être réalisée.
La figure 1 présente un schéma électrique d'un premier exemple de circuit de commutation selon l'invention,
la figure 2 est un graphique montrant l'allure de la mise en conduction d'un miroir de courant du circuit de la figure 1 en fonction du temps, et
la figure 3 est un schéma électrique d'un deuxième exemple de circuit de commutation selon un mode préféré de mise en oeuvre de l'invention,
et la figure 4 est une vue schématique d'une application de l'invention à un appareil de stockage d'informations numériques.

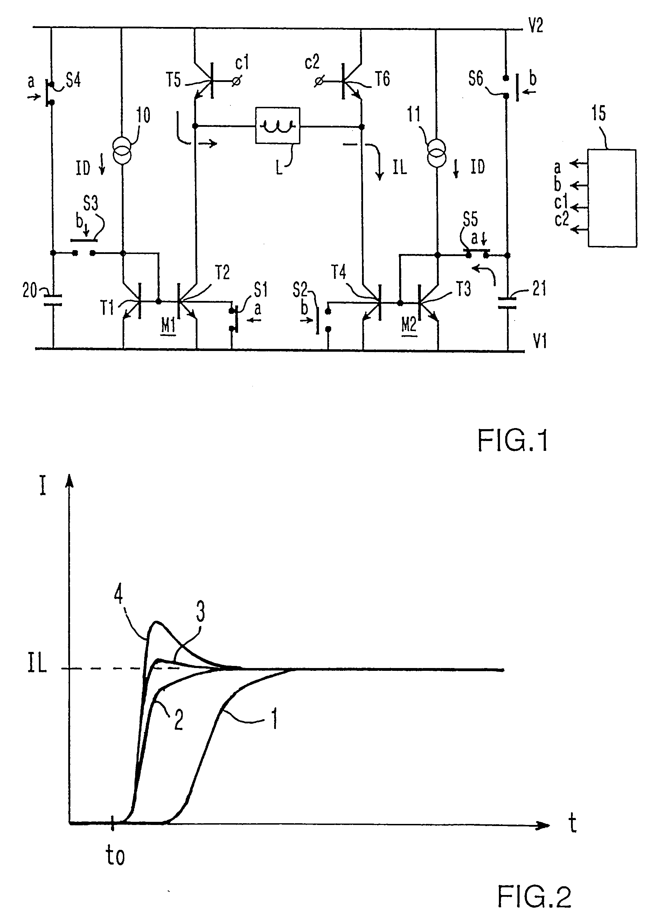

Le schéma de la figure 1 montre un circuit de commutation d'un courant IL dans une charge L qui est de type inductif tel qu'une tête d'écriture sur un disque magnétique par exemple. Il comporte deux miroirs de courant M1, M2, formés respectivement des transistors T1, T2, T3 et T4. Les émetteurs de ces transistors sont reliés à une borne de tension d'alimentation V1 servant de référence de tension. L'autre borne de tension d'alimentation porte une tension positive V2. Le transistor T1, connecté en diode constitue l'entrée du miroir de courant M1 qui est alimentée par une source de courant 10 débitant sur cette entrée un courant ID. De manière symétrique, le transistor T3, connecté en diode, constitue l'entrée du miroir de courant M2 qui est alimentée par une autre source de courant 11 débitant un courant ID de même valeur que le courant débité par la source 10. Le collecteur du transistor T2 qui forme la sortie du miroir de courant M1 est connecté à une extrémité de la charge L ainsi qu'à l'émetteur d'un transistor T5 dont le collecteur est couplé à la borne d'alimentation V2. De manière symétrique le collecteur du transistor T4, qui forme la sortie du miroir de courant M2 est connecté à l'autre extrémité de la charge L ainsi qu'à l'émetteur d'un transistor T6 dont le collecteur est couplé à la borne d'alimentation V2. Les miroirs de courant M1, M2 et les transistors T5 et T6 forment un amplificateur en H permettant de faire circuler le courant IL dans la charge L alternativement dans un sens et dans l'autre.

Dans ce but, un générateur de signaux de commande 15 fournit des signaux a, b, c1 et c2, signaux dans lesquels le signal b est le complément logique du signal a et le signal c2 est le complément logique du signal c1. Par ailleurs les signaux a et c1 sont en phase. Le signal c1 est appliqué à la base du transistor T5, qui fonctionne à la manière d'un interrupteur, plaçant ce transistor dans un état passant ou bloqué. Le signal c2 est appliqué à la base du transistor T6 et joue le même rôle, mais inversé, que le signal c1 relativement au transistor T5. Le signal a et son complément logique b sont appliqués à une série d'interrupteurs parmi lesquels l'interrupteur S1 est disposé de manière à shunter la base des transistors T1 et T2 vers la tension de référence V1 et l'interrupteur S2 est disposé d'une manière symétrique pour shunter les bases des transistors T3 et T4 vers la même tension V1. A l'interrupteur S1, est appliqué le signal de commande a et à l'interrupteur S2 est appliqué le signal de commande b. De cette manière, les miroirs de courant M1 et M2 débitent alternativement un courant IL qui, de préférence, est un multiple des courants de commande ID, ces miroirs de courant étant prévus avec un rapport de courant de sortie sur courant d'entrée plus grand que 1.

Comme le courant IL nécessaire à l'alimentation de la charge L peut être relativement élevé, de l'ordre de 40mA, il est avantageux que le courant ID soit nettement plus petit de manière à minimiser la surface occupée par les transistors T1, T3 et ceux constituant les sources de courant 10 et 11.

Pour accélérer la conduction des miroirs de courant M1 et M2, il est prévu selon l'invention une capacité 20 associée au miroir de courant M1 ainsi qu'une capacité 21 associée au miroir de courant M2.

La capacité 20 peut être couplée sur l'entrée du miroir de courant M1 par l'effet d'un interrupteur S3 soumis au signal de commande b, soit encore couplée, via un interrupteur S4, à la tension d'alimentation V2 permettant la charge de cette capacité 20.

De manière symétrique, la capacité 21 est susceptible d'être couplée à l'entrée du miroir de courant M2 par un interrupteur S5 soumis au signal de commande a, ou encore chargée à la tension d'alimentation V2 par un interrupteur S6 soumis au signal de commande b. De cette manière, le délai de charge des capacités parasites d'entrée des miroirs de courant M1 et M2 peut être compensé par un apport de charge fourni par les capacités 20 et 21.

La figure 2 présente l'allure des courbes d'établissement du courant IL débité à la sortie de l'un des miroirs de courant M1 ou M2 en fonction du temps t.

La courbe 1 montre un retard d'établissement du courant I par rapport à l'instant to du départ de la commutation, en l'absence des capacités 20 et 21, courant qui se stabilise à la valeur IL.

Les courbes 2, 3 et 4 présentent l'allure des transitoires de courant pour des capacités 20 et 21 croissantes, la courbe 3 présentant un léger dépassement initial, par comparaison avec la courbe 2 tandis qu'avec la courbe 4 le dépassement initial est plus important. Ce comportement des miroirs M1 et M2 s'explique du fait que les capacités 20 et 21 sont chargées à une tension V2 qui est nettement plus élevée que la tension de jonction des transistors, de l'ordre de 0,7 Volt, tension qui est nécessaire pour les débloquer. Par ailleurs, il est clair que la valeur optimale des capacités 20 et 21 est nettement inférieure aux capacités parasites d'entrée des miroirs de sorte que cette valeur optimale est en général très petite et donc très aisément intégrable dans un circuit intégré.

Du point de vue de la réalisation du circuit décrit à la figure 1, il est le plus souvent avantageux que le générateur de signaux de commande 15 soit formé avec des transistors à effet de champ MOS qui sont peu encombrants et permettent une grande souplesse de réalisation. Lorsque de tels transistors sont réalisés dans le même procédé que des transistors bipolaires constituant le circuit amplificateur de moyenne puissance, il est avantageux également de réaliser les interrupteurs S1 à S6 avec des transistors à effet de champ MOS.

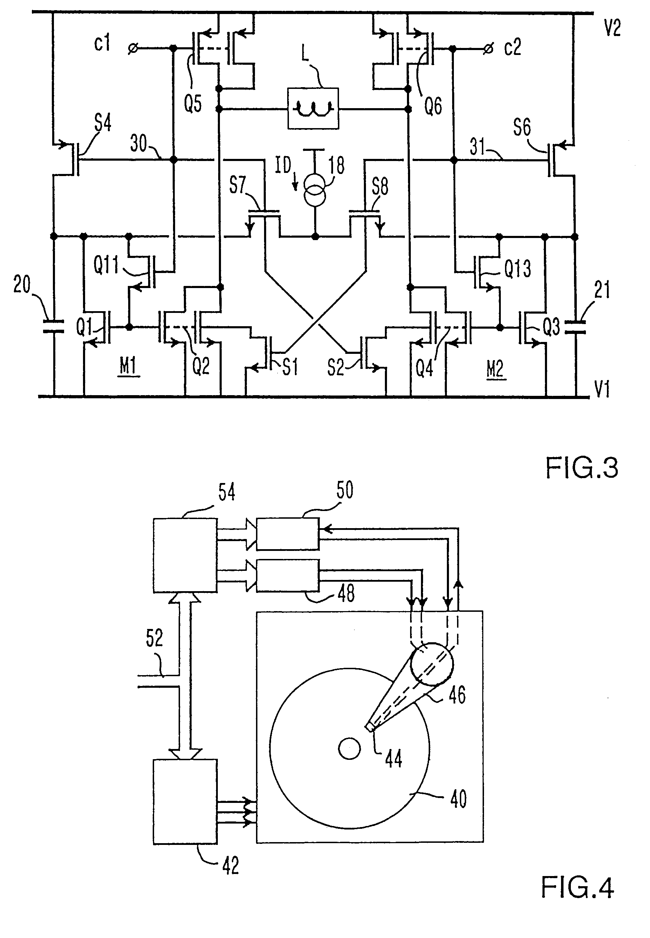

Le circuit représenté à la figure 3 montre un autre exemple de réalisation de l'invention dans une version utilisant uniquement des transistors MOS de type complémentaire.

Un miroir de courant M1 est constitué de transistors MOS à canal n, un transistor Q1 formant la branche d'entrée de ce miroir et un transistor Q2, la branche de sortie, miroir dont le coefficient multiplicatif de courant est symbolisé sur la figure par une pluralité de transistors élémentaires connectés en parallèle. De manière symétrique, le miroir de courant M2 est formé d'un transistor d'entrée Q3 et d'un transistor de sortie Q4 présentant le même coefficient de multiplication de courant. Le drain du transistor Q2 est connecté à une borne de la charge L ainsi qu'au drain d'un transistor Q5 de type MOS à canal p. Le transistor Q5 est un transistor de taille convenable pour transmettre le courant désiré dans la charge L et peut également être constitué d'une pluralité de transistors connectés en parallèle. De manière symétrique, dans le miroir de courant M2, le transistor de sortie Q4 a son drain connecté à une extrémité de la charge L ainsi qu'au drain d'un transistor Q6, à canal p, homologue du transistor Q5.

A la grille du transistor Q5 est appliqué un signal de commande c1 analogue au signal décrit à propos de la figure 1, et à la grille du transistor Q6 est appliqué le signal de commande c2 complément logique du signal c1.

Le signal de commande c1 est également appliqué à la grille d'un transistor S4 à canal p, jouant le rôle de l'interrupteur portant la même référence à la figure 1 et disposé de la même manière, pour la charge de la capacité 20 associée au miroir de courant M1.

Les miroirs de courant M1 et M2 sont alimentés en entrée par un courant ID provenant d'une source de courant 18 qui, contrairement au schéma de la figure 1 est ici une source de courant unique. Le courant ID est alternativement délivré à l'entrée du miroir de courant M1 ou à l'entrée du miroir de courant M2 par le jeu de deux transistors interrupteurs S7 et S8 qui sont des transistors à canal n. Le transistor S7 reçoit le signal de commande c1 et le transistor S8 reçoit le signal de commande c2. Sous l'effet du signal de commande c1, le courant ID peut donc être acheminé sur une ligne 30 reliant le drain du transistor S4 à la capacité 20, au drain du transistor Q1, et à la source du transistor S7. Le drain du transistor Q1 est couplé aux grilles des transistors Q1 et Q2 par un transistor interrupteur Q11 de type MOS à canal n, dont la grille reçoit le même signal de commande c1. De ce fait, les transistors S7 et Q11 sont conducteurs simultanément.

Symétriquement, une disposition similaire est réalisée avec le miroir de courant M2 et des transistors jouant le rôle d'interrupteur S6, S8, Q13 qui reçoivent tous sur leurs grilles le signal de commande c2. Lorsque le courant ID de la source courant 18 est distribué sur la ligne 31 symétrique de la ligne 30, le transistor S6 est bloqué, le transistor S8 est conducteur, ainsi que le transistor Q13. La capacité 21 est alternativement chargée à la tension d'alimentation V2 puis déchargée en parallèle sur la capacité parasite d'entrée du miroir de courant M2.

La décharge des capacités 20 et 21 respectivement sur l'entrée des miroirs de courant M1 et M2 provoque, comme on l'a vu précédemment, une accélération très sensible du temps d'établissement du courant dans les miroirs de courant. La transitoire de retour à zéro du courant de sortie de ces mêmes miroirs peut être avantageusement accélérée par un shunt de la capacité parasite d'entrée des miroirs, qui est réalisé de manière similaire au circuit de la figure 1, à l'aide de deux transistors à canal n, S1 et S2. Le transistor S1 permet une mise à la tension de référence V1 des grilles des transistors Q1 et Q2 et le transistor S2 réalise la même fonction pour les grilles des transistors Q3 et Q4. Le transistor S1 reçoit le signal de commande c2 et le transistor S2 reçoit le signal de commande c1.

On observe encore ici le fait que les capacités 20 et 21 peuvent être réalisées aisément de manière intégrée du fait qu'elles ne nécessitent qu'une fraction de la capacité équivalente d'entrée des miroirs M1 et M2.

La figure 4 représente très schématiquement un exemple d'application du circuit de commutation de courant selon l'invention à un appareil de stockage d'informations numériques sur un disque magnétique. Le disque magnétique 40 est entrainé en rotation par un moteur, non représenté sur la figure, à partir d'une commande de courant triphasé issue d'un bloc de commande de puissance 42. Un ensemble de têtes 44 de lecture/écriture peut être déplacé sur le disque 40 au moyen d'un bras 46 mû par un moteur non visible sur la figure, moteur qui est alimenté par un circuit de commande de puissance 48.

Un bloc de contrôle 50 fournit des signaux de commande d'écriture et reçoit des signaux de lecture des têtes 44. Le bloc de contrôle 50 contient un circuit de commutation de courant tel qu'il a été décrit précédemment.

Un ensemble de liaisons 52 véhicule des signaux de commande vers le bloc de commande 42 pour le contrôle de la vitesse de rotation du disque 40 ainsi que vers un bloc 54 de gestion des têtes de lecture/écriture. A partir du bloc de gestion 54, des liaisons de commande sont dirigées vers le bloc de contrôle 50 et vers le circuit de commande de puissance 48 pour la gestion des têtes de lecture/écriture.

Dans un tel appareil, l'utilisation du circuit de commutation de courant selon l'invention permet d'obtenir une écriture des données sur le disque 40 à fréquence élevée, comme cela est souhaité en vue d'une amélioration des performances de l'appareil.

## Revendications

1. Circuit de commutation de courant d'une charge, comportant au moins deux miroirs de courant présentant chacun une entrée et une sortie, disposés de manière à alimenter la charge entre deux bornes d'une alimentation, alternativement dans un sens ou dans l'autre, via la sortie de l'un ou de l'autre des miroirs de courant, chacun étant alternativement actionné au moyen d'un courant de commande injecté dans son entrée, caractérisé en ce qu'à chacun des miroirs de courant est associée une capacité et un jeu de dispositifs interrupteurs, connectés et actionnés de manière à coupler la capacité, soit en parallèle sur l'entrée du miroir de courant auquel elle est associée lorsque ce miroir, recevant le courant de commande, débite, soit aux bornes de l'alimentation lorsque ce miroir de courant ne débite pas.

2. Circuit de commutation de courant selon la revendication 1, caractérisé en ce que les miroirs de courant présentent un rapport courant de sortie sur courant d'entrée qui est supérieur à l'unité.

3. Circuit de commutation de courant selon la revendication 1, caractérisé en ce que le courant de commande injecté alternativement dans l'un ou l'autre des miroirs de courant provient d'une même source de courant, dont le courant est commuté vers l'une ou l'autre des entrées des miroirs de courant par des dispositifs interrupteurs.

4. Circuit de commutation de courant selon la revendication 1, caractérisé en ce que, en parallèle sur l'entrée de chacun des miroirs de courant, est connecté un dispositif interrupteur additionnel, actionné de manière à shunter cette entrée lorsque le miroir de courant ne débite pas.

5. Circuit de commutation de courant selon l'une des revendications 1 à 4, caractérisé en ce que les dispositifs interrupteurs sont des transistors de type à effet de champ MOS.

6. Circuit de commutation de courant selon l'une des revendications 1 à 4, caractérisé en ce que les transistors formant les miroirs de courant sont des transistors de type à effet de champ MOS.

7. Appareil de stockage d'informations numériques utilisant une tête d'écriture de type inductif, caractérisé en ce que pour actionner la tête d'écriture, il comporte un circuit de commutation de courant selon l'une des revendications 1 à 6.
